# EUROPÄISCHE PATENTSCHRIFT

(11) **EP 1 638 381 B1**
(45) Veröffentlichungstag und Bekanntmachung des Hinweises auf die Patenterteilung: **14.07.2010**
(21) Anmeldenummer: 05015525.8
(22) Anmeldetag: 18.07.2005
(51) Int. Cl.: H05K 5/02

(54) **Gehäuse und Gehäuseanordnung**
Casing and casing device
Boîtier et dispositif de boîtier

(30) Priorität: 09.08.2004 DE 202004012462 U
(43) Veröffentlichungstag der Anmeldung: 22.03.2006
(73) Patentinhaber: Rose Systemtechnik GmbH & Co. KG, 32457 Porta Westfalica (DE)
(72) Erfinder: Schaadt, Dieter B., 32429 Minden (DE); Heim, Andreas, 32312 Lübbecke/Minden (DE)
(74) Vertreter: Philipp, Matthias

(56) Entgegenhaltungen:
- EP-A- 1 439 746
- DE-A1- 19 924 344
- DE-U1- 29 712 951
- DE-U1- 29 800 501
- DE-U1- 29 800 502
- FR-A- 2 838 621

## Beschreibung

Die Erfindung betrifft ein Gehäuse, insbesondere Elektronikgehäuse mit einem Hohlprofilförmigen Gehäusekörper und mindestens einem stirnseitig angeschraubten Deckel, einen Gehäusekörper und eine mit einem solchen Gehäuse gebildete Gehäuseanordnung.

Bei einem derartigen bekannten Gehäuse, bei dem der Gehäusekörper insbesondere als Strangpreßteil aus Kunststoff oder Leichmetall hergestellt ist, ist der Deckel mit Befestigungsschrauben befestigt, die in Befestigungslöcher eingeschraubt sind, welche in verstärkten Eckbereichen des Gehäusekörpers in Form von Sacklöchern gebohrt und mit Innengewinde versehen sind. Ein Gehäuse der vorstehend genannten Art ist aus EP 1 439 746 bekannt.

Eine derartige Herstellungsweise des Gehäusekörpers ist relativ kostenaufwendig.
Die Aufgabe der Erfindung besteht darin, ein gattungsgemäßes Gehäuse insbesondere im Hinblick auf die Deckelbefestigung zu verbessern und zu vereinfachen.

Eine weitere Aufgabe der Erfindung besteht darin, in möglichst einfacher Weise eine außenseitige Befestigungsmöglichkeit für Funktionselemente wie Griffe, Aufstellfüße, Befestigungselemente o.ä. zu schaffen.

Die Aufgabe der Erfindung wird durch ein Gehäuse, insbesondere Elektronikgehäuse, mit einem hohlprofilförmigen Gehäusekörper und mindestens einem stirnseitig an diesem angeschraubten Deckel gelöst, wobei sich das Gehäuse dadurch auszeichnet, daß der Gehäusekörper außenseitig angeformte, nach außen offene und in einer Längsrichtung des Gehäuses verlaufende Befestigungskanäle aufweist, in die Befestigungselemente für den mindestens einen Deckel eingreifen.

Durch diese Maßnahme können einerseits diejenigen Bereiche, die bisher der Aufnahme der Befestigungsschrauben dienten, weniger dick ausgeführt werden, da keine Bohrungen mehr erforderlich sind, und außerdem können die Bohr- und Gewindeherstellungsvorgänge entfallen.

Bevorzugt ist vorgesehen, daß die Befestigungselemente Schrauben, insbesondere selbstschneidende Schrauben, sind, die in die Befestigungskanäle eingeschraubt sind.

Zweckmäßigerweise ist vorgesehen, daß der Gehäusekörper stranggepreßt ist, insbesondere aus Kunststoff oder Leichtmetall.

Besonders vorteilhaft ist es, wenn der Gehäusekörper mindestens zwei außenseitig angeformte und in Längsrichtung verlaufende, paarweise ausgebildete Haltenuten zur Aufnahme eines Einschubteils je Haltenutenpaar aufweist.

Weiterhin ist vorgesehen, daß die Haltenuten zueinander gerichtet sind, wobei dann das Einschubteil als im wesentlichen ebene Platte ausgebildet sein kann.

In bevorzugter Weiterbildung ist vorgesehen, daß jeder Befestigungskanal einen ersten Querschnittsbereich zur Aufnahme einer Befestigungsschraube und einen daran anschließenden, zweiten Querschnittsbereich zur Bildung einer Haltenut aufweist.

Der erste Querschnittsbereich kann rund sein, während der zweite Querschnittsbereich bevorzugt rechteckförmig ausgebildet ist.

Es ist vorteilhaft, wenn je zwei Haltenuten in einer gemeinsamen Ebene ausgebildet sind.

Es kann vorgesehen sein, daß in mindestens einem Paar von Haltenuten ein Einschubteil aufgenommen ist, das durch angeschraubte Deckel gesichert ist. Die Länge des Einschubteils kann mit der des Gehäusekörpers übereinstimmen, oder das Einschubteil kann kürzer sein und ggf. an einer gewünschten Längsposition an dem Gehäusekörper feststellbar sein.

In einer Ausführungsform ist vorgesehen, daß das Einschubteil ein ebener oder profilierter Materialstreifen ist.

Bevorzugt ist vorgesehen, daß mindestens ein Funktionselement wie Griff, Befestigungselement, Rastelement oder Aufstellfuß an dem Einschubelement oder an einem Deckel gehalten oder unmittelbar in die Haltenuten eingesetzt ist. Auch hier kann vorgesehen sein, daß das Funktionselement, sofern es unmittelbar in die Haltenuten eingesetzt ist, an einer gewünschten Längsposition fixierbar ist.

Es besteht die Möglichkeit, daß mindestens ein U-förmiger Rastbügel zur Halterung einer stirnseitig aufrastbaren Abdeckung oder Haube an dem Einschubteil gehalten oder unmittelbar in die Haltenuten eingesetzt ist.

Es kann vorgesehen sein, daß der Gehäusekörper im wesentlichen rechteckförmigen Querschnitt mit zwei Paaren von Befestigungskanälen aufweist.

Zweckmäßigerweise ist vorgesehen, daß jeder Befestigungskanal in einem Eckbereich des Gehäusekörpers angeordnet ist.

Eine besonders vorteilhafte Ausführung zeichnet sich dadurch aus, daß jeder Befestigungskanal in einem an eine Gehäuseseite angeformten C-förmigen Gehäusevorsprung ausgebildet ist. Hierbei kann vorgesehen sein, daß je zwei der C-förmigen Gehäusevorsprünge mit ihren offenen Bereichen die Haltenuten bilden und zueinander weisend angeordnet sind.

Weiter besteht die Möglichkeit, daß in dem Gehäusekörper in Längsrichtung verlaufende Führungen für Einschubelemente, insbesondere Leiterplatten, ausgebildet sind. Die Führungen können in zwei zueinander senkrechten Richtungen angeordnet sein.

Eine zweckmäßige Ausgestaltung zeichnet sich dadurch aus, daß auf zwei benachbarte Gehäusevorsprünge ein diese formschlüssig übergreifendes Fußteil aufgerastet ist.

Die Erfindung bezieht sich weiter auf eine Gehäuseanordnung mit mindestens zwei Gehäusen gemäß der Erfindung, die sich dadurch auszeichnet, daß die Gehäuse an ebenen Außenflächen aneinanderliegen, wobei je zwei Gehäuse mit mindestens einem die C-förmigen Gehäusevorsprünge formschlüssig übergreifenden Halteteil aneinander gehalten sind, das doppel-T-förmig mit einem Mittelsteg und je zwei Haltestegen ausgebildet ist, wobei die Haltestege jeweils einen Gehäusevorsprung übergreifen und der Mittelsteg zwischen den zwei Außenflächen der Gehäuse angeordnet ist.

Hierbei kann vorgesehen sein, daß je zwei Gehäuse mit je zwei Halteteilen aneinander gehalten sind.

Bevorzugt ist vorgesehen, daß die Halteteile elastisch und auf die Gehäuse auf- und von diesen entrastbar sind.

Weitere Vorteile und Merkmale der Erfindung ergeben sich aus der nachfolgenden Beschreibung einer bevorzugten Ausführungsform, wobei auf eine Zeichnung Bezug genommen ist, in der
Fig. 1 eine stirnseitige Ansicht eines erfindungsgemäßen Gehäusekörpers zeigt,
Fig. 2 einen Teil des in Fig. 1 dargestellten Gehäusekörpers in einem vergrößerten Maßstab zeigt,
Fig. 3 den Gehäusekörper nach Fig. 1 in einer perspektivischen Ansicht zeigt,
Fig. 4 ein Einschubteil in Form eines profilierten Materialstreifens in einer Stirnansicht und einer vergrößerten Teilansicht zeigt,
Fig. 5 eine auseinandergezogene Darstellung eines erfindungsgemäßen Gehäuses mit Gehäusegrundkörper, zwei Einschubteilen und zwei Deckeln zeigt,
Fig. 6 eine perspektivische Ansicht eines Rastelements als Haubenverriegelung zeigt,
Fig. 7 eine Schnittansicht des Rastelements nach Fig. 6 zeigt,
Fig. 8 eine Vorderansicht des Rastelements nach Fig. 6 zeigt,
Fig. 9 eine perspektivische Ansicht einer Klarsichthaube zeigt,
Fig. 10 und 11 eine Vorderansicht und eine Seitenansicht der Klarsichthaube nach Fig. 8 zeigen,
Fig. 12 und 13 zwei Seitenansichten aus unterschiedlichen Richtungen eines erfindungsgemäßen Gehäuses entsprechend Fig. 5 mit einer auf Rastelemente gemäß Fig. 6 bis 8 aufgerasteten Haube gemäß Fig. 9 bis 11 zeigen,
Fig. 14 eine Längsschnittansicht des Gehäuses nach Fig. 12 zeigt,
Fig. 15 eine perspektivische Ansicht einer erfindungsgemäßen Gehäuseanordnung mit vier Gehäusen und acht Halteteilen zeigt,
Fig. 16 eine Seitenansicht der Gehäuseanordnung nach Fig. 15 zeigt,
Fig. 17 eine weitere Seitenansicht der Gehäuseanordnung nach Fig. 15 zeigt,
Fig. 18 eine perspektivische Ansicht eines in der Gehäuseanordnung nach Fig. 15 bis 17 verwendeten Halteteils zeigt, und
Fig. 19 eine Seitenansicht des Halteteils nach Fig. 18 zeigt.

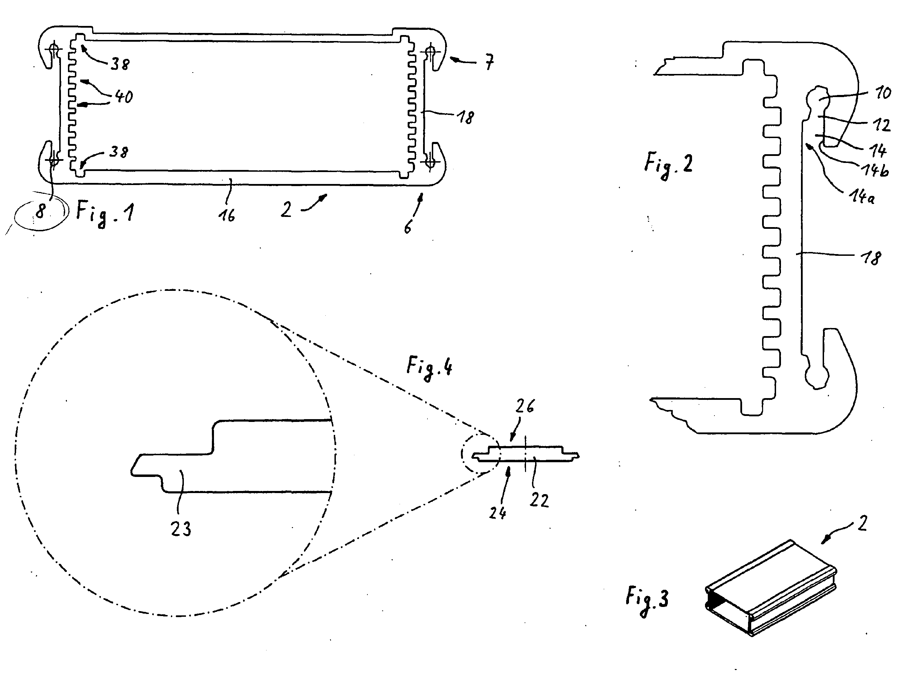

Fig. 1 bis 3 erläutern den Aufbau eines erfindungsgemäßen Gehäusekörpers 2, der einen wesentlichen Bestandteil eines erfindungsgemäßen Gehäuses 4 darstellt. Der Gehäusekörper 2 eines bestimmten, eine vorgegebenen Länge aufweisenden Gehäuses besteht aus einem entsprechenden Längenabschnitt eines Strangpreßprofils, dessen Querschnittsform in Fig. 1 und 2 dargestellt sind. Der Gehäusekörper 2 weist einen im wesentlichen rechteckförmigen Querschnitt mit verstärkten bzw. verdickten Eckbereichen 6 auf, wobei an jedem Eckbereich nach außen vorstehende C- bzw. U-förmige Gehäusevorsprünge 7 ausgebildet sind, so daß außenseitig an dem Gehäusekörper 2 nach außen offene, in Längsrichtung verlaufende Befestigungskanäle 8 gebildet sind.

Fig. 2 zeigt die Befestigungskanäle 8 in vergrößertem Maßstab. Jeder Befestigungskanal 8 weist einen ersten, im Querschnitt im wesentlichen runden Querschnittsbereich 10 auf, der in noch zu erläuternder Weise die Funktion eines Schraubkanals hat, einen daran anschließenden verengten Bereich 12 und einen an diesen anschließenden, zweiten Querschnittsbereich 14, der zu dem verengten Bereich 12 sowie nach außen hin offen ist und ansonsten eine im wesentlichen rechteckförmige Querschnittsgestalt mit parallelen Wänden 14a, b aufweist.

Die jeweils paarweise angeordneten Befestigungskanäle 8 sind so ausgerichtet, daß sie in Richtung zueinander geöffnet sind, d.h. daß die zweiten Querschnittsbereiche 14 zueinander weisen und in dem dargestellten Beispiel in einer Ebene liegen. Bei dem Gehäusekörper nach Fig. 1 und 2, der zwei breite Seitenwände 16 und zwei schmale Seitenwände 18 aufweist, sind die Befestigungskanäle 8 jeweils paarweise einer schmalen Seitenwand 18 zugeordnet, und die zweiten Querschnittsbereiche 14 sind parallel zu der schmalen Seitenwand 18 ausgerichtet.

Erfindungsgemäß sind durch die zweiten Querschnittsbereiche 14 Haltenuten gebildet, in die ein Einschubteil 22 eingesetzt werden kann, das im einfachsten Fall aus einem im wesentlichen ebenen Materialstreifen mit seitlichen Führungsleisten 23 besteht und in Fig. 4 in einer stirnseitigen Ansicht dargestellt ist. Das Einschubteil 22 wird von einem Ende her so in die Haltenuten 14 eingeschoben, daß seine Unterseite 24 gegen eine Außenseite 26 der schmalen Seitenwand 18 anliegt. Das Einschubteil 22 kann beispielsweise zu Kennzeichnungszwecken des Gehäuses oder als sonstiger Informationsträger dienen, oder es können Funktionselemente wie Griffe, Befestigungselemente, Rastelemente oder Aufstellfiiße etc. daran befestigt sein, oder derartige Funktionselemente können ähnlich wie das Einschubteil 22 mit seitlichen Führungsleisten versehen sein, die in die Haltenuten 14 eingreifen, und ein oder mehrere wie vorstehend beschriebene Führungsteile können zur Lagesicherung eines solchen Funktionselements in Längsrichtung der Befestigungskanäle 8 (Richtung senkrecht zur Darstellungsebene der Fig. 1 und 2) dienen.

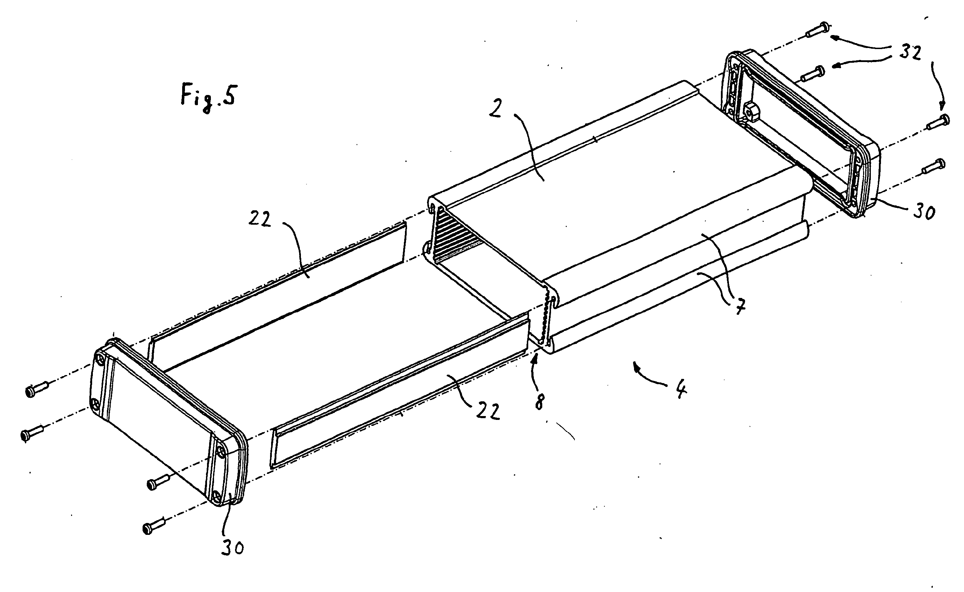

Fig. 5 zeigt eine Explosionsdarstellung eines erfindungsgemäßen Gehäuses 4, wobei neben dem Gehäusekörper 2 und zwei Einschubteilen 22 zwei seitliche Deckel 30 dargestellt sind, die stirnseitig auf den Gehäusekörper aufgeschraubt werden und die Einschubteile 22 in Einschubrichtung fixieren. Erfindungsgemäß greifen Befestigungsschrauben 32 der Deckel 30 in die Befestigungskanäle 8, wobei es sich bevorzugt um selbstschneidende Schrauben handelt. Besonders vorteilhaft ist hierbei, daß es nicht erforderlich ist, die Befestigungskanäle 8 in einem gesonderten Arbeitsgang beispielsweise durch Bohren herzustellen, und daß auch kein Gewinde geschnitten werden muß. Etwaige Materialspäne, die beim Einschrauben bzw.

Einschneiden der Befestigungsschrauben 32 entstehen, können nicht ins Innere des Gehäuses 4 gelangen, da sich die Befestigungskanäle 8 auf dessen Außenseite befinden.

Ein weiterer Vorteil dieser Befestigungstechnik liegt darin, daß die Einschubteile 22 ebenfalls durch die Befestigungsschrauben 32 in ihrer Lage fixiert bzw. zentriert werden, da die Einschubteile mit ihren Führungsleisten 23 zum Teil bis in die ersten Querschnittsbereiche 10, d.h. die Schraubkanäle, hineinragen.

Wie Fig. 1 und 2 weiter zeigen, sind in dem Gehäusekörper 2 in Längsrichtung verlaufende Führungen 38, 40 ausgebildet, die senkrecht zueinander angeordnet sind und der Aufnahme von Einschubelementen dienen, beispielsweise von mit Elektronikelementen bestückten Leiterplatten, oder von Adapterelementen zur um 90° gedrehten Aufnahme von Elektronikelementen. Ähnlich wie die schmalen Seitenwände 18 können auch die breiten Seitenwände 16 mit einer größeren Anzahl von Führungsleisten 38 versehen sein, die über die Breite der Seitenwand verteilt angeordnet sind.

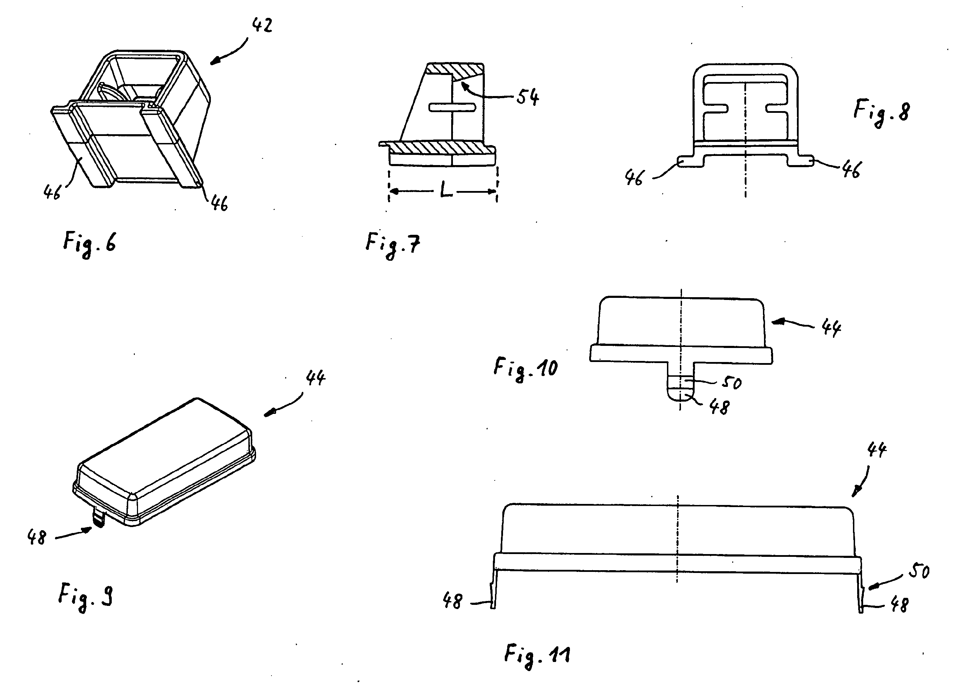

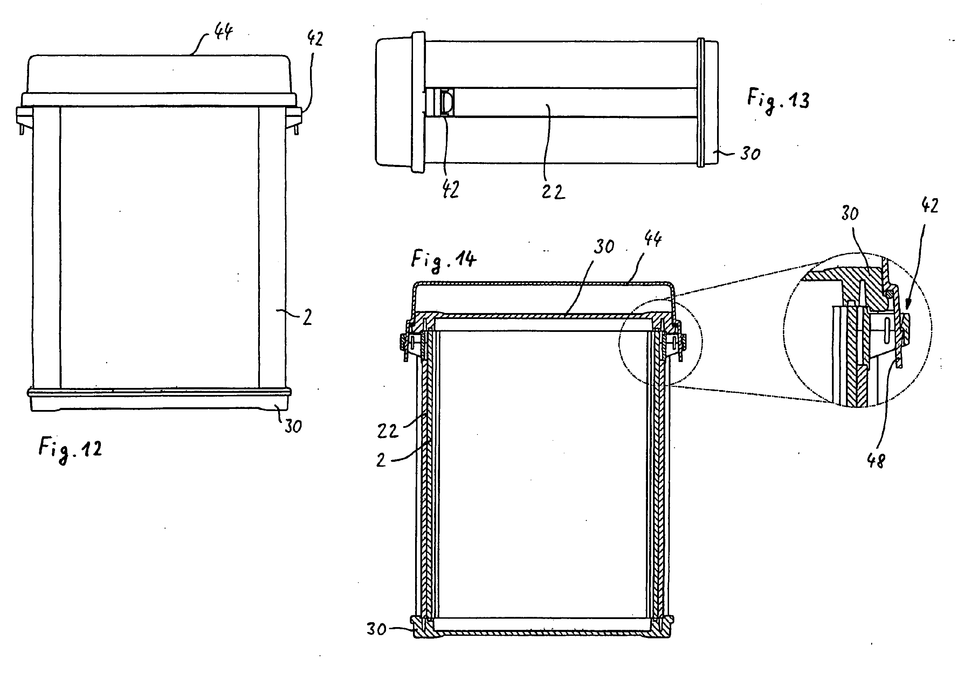

Fig. 6 bis 8 zeigen ein weiteres Beispiel für ein Einschubteil 42, das einer lösbaren Befestigung einer Haube 44 dient, die in Fig. 9 bis 11 und mit Gehäuse in Fig. 12 bis 14 dargestellt ist.

Wie vorstehend bereits angedeutet, kann das Einschubteil 42 mit Hilfe von seitlich ausgebildeten Führungsleisten 46 in die Haltenuten 14 eingeschoben werden, wobei jeweils eine Führungsleiste 46 in eine Haltenut 14 greift. Zum Einsetzen des Einschubteils 42 muß selbstverständlich ein Deckel 30 von dem Gehäusekörper 2 abgenommen sein und ein leistenförmiges Einschubteil 22, soweit vorhanden, herausgezogen werden.

Wenn das Einschubteil 42 an einem stirnseitigen Ende des Gehäusekörpers 2 aufgenommen und in seiner Lage fixiert sein soll, kann beispielsweise ein leistenförmiges Einschubteil 22 um die Länge L des Einschubteils 42 gekürzt werden und zusammen mit diesem in die Haltenuten eines Paars von Befestigungskanälen eingeschoben werden und im eingeschobenen Zustand durch Aufschrauben des Deckels 30 fixiert werden. Wenn dies auf beiden Seiten des Gehäuses erfolgt, kann die Haube 44 aufgesetzt und aufgerastet werden, indem sie auf einen Deckel 30 aufgesetzt und mit Rastzungen 48 in die Einschubteile 42 eingesetzt wird, wobei Rastvorsprünge 50 auf den Rastzungen 48 hinter Rastnasen 54 in den Einschubteilen 42 greifen und für eine formschlüssig eingerastete Arretierung der Haube 44 dem Gehäuse sorgen.

In ähnlicher Weise wie anhand des Einschubteils 42 veranschaulicht ist, könnten andere Funktionselemente wie beispielsweise Griffe und Füße oder Befestigungselemente wie Bügel, Laschen o.ä. oder sonstige Rast- oder Halterungselemente mit Führungsleisten versehen sein, so daß sie in eine durch ein Paar von Befestigungskanälen 8 gebildete Führung einsetzbar sind. Eine Fixierung eines derartigen Einschubteils an einer gewünschten Längsposition der Befestigungskanäle kann grundsätzlich in jeder beliebigen Weise erfolgen, beispielsweise mittels Klemmelementen oder Klemmschrauben, am einfachsten allerdings durch ein oder mehrere leistenförmige(s) Einschubteil(e) ähnlich wie das Einschubteil 22, wobei dann die Fixierung in Längsrichtung durch Zusammenwirken der leistenförmigen Einschubteile mit den angeschraubten Deckeln 30 erfolgt.

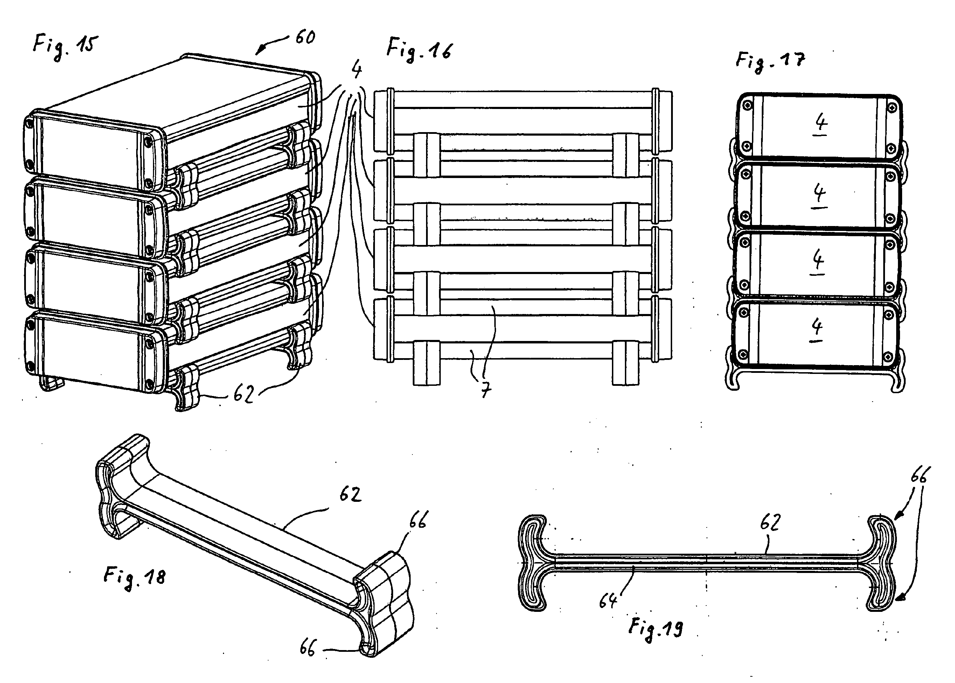

Fig. 15 bis 17 zeigen eine erfindungsgemäße Gehäuseanordnung 60, die aus mehreren, in diesem Beispiel vier, einzelnen erfindungsgemäßen Gehäusen 4 besteht, wobei jedes Gehäuse etwa entsprechend Fig. 5 aufgebaut ist. Jedes Gehäuse ist mit einem benachbarten Gehäuse durch zwei doppel-T-förmige Halteteile 62 verbunden, die in Fig. 18 und 19 gesondert dargestellt sind.

Fig. 16 zeigt eine Seitenansicht von einer Schmalseite der Gehäuse, während Fig. 17 eine Ansicht von den Stirnseiten bzw. Deckelseiten zeigt.

Jedes Halteteil 62 weist einen länglichen Mittelsteg 64 und an dessen Enden jeweils zwei seitlich davon abgehende, klammerartige Haltestege 66 auf. Das Halteteil 62 ist bevorzugt im Bereich der Haltestege 66 elastisch ausgebildet, so daß diese über die Gehäusevorsprünge 7 aufgerastet bzw. davon entrastet werden können.

Wie Fig. 15 bis 17 weiter zeigen, können die Halteteile bzw. eines davon nicht nur als Verbindungselement zwischen zwei Gehäusen, sondern auch als Fuß- bzw. Aufstellelement dienen. Bei Verwendung nur eines Halteteils als Aufstellelement läßt sich eine schräg geneigte Aufstellung eines oder mehrerer Gehäuse auf einer ebenen Unterlage erzielen.

### Bezugszeichenliste

- 2: Gehäusekörper
- 4: Gehäuse
- 6: Eckbereich
- 7: Gehäusevorsprung
- 8: Befestigungskanal
- 10: erster Querschnittsbereich (Schraubkanal)
- 12: verengter Bereich
- 14: zweiter Querschnittsbereich (Haltenut)
- 14a, b: Wand
- 16: breite Seitenwand
- 18: schmale Seitenwand
- 22: Einschubteil
- 23: Führungsleiste
- 24: Unterseite (von 22)
- 26: Außenseite (von 18)
- 30: Deckel
- 32: Befestigungsschraube
- 38,40: Führung
- 42: Einschubteil
- 44: Haube
- 46: Führungsleiste
- 48: Rastzunge
- 50: Rastvorsprung
- 54: Rastnase
- 60: Gehäuseanordnung
- 62: Halteteil
- 64: Mittelsteg
- 66: Haltesteg

- L: Länge (von 42)

## Patentansprüche

1. Gehäusekörper (2), insbesondere für Elektronikgehäuse, mit hohlprofilförmigem Querschnitt und mindestens zwei paarweise angeordneten, außenseitig angeformten, nach außen offenen und in Längsrichtung des Gehäusekörpers (2) verlaufenden Befestigungskanälen (8) zur Aufnahme von Befestigungselementen (32) für einen Deckel, **dadurch gekennzeichnet, daß** jeder Befestigungskanal (8) einen ersten Querschnittsbereich (10) zur Aufnahme einer Befestigungsschraube (32) und einen daran anschließenden, eine nach außen offene Haltenut (14) bildenden Querschnittsbereich aufweist in die ein Einschubteil 22 eingesetzt werden kann.

2. Gehäusekörper nach Anspruch 1, **dadurch gekennzeichnet, daß** die Befestigungselemente Schrauben (32), insbesondere selbstschneidende Schrauben sind, die in die Befestigungskanäle (8) eingeschraubt sind.

3. Gehäusekörper nach Anspruch 1 oder 2, **dadurch gekennzeichnet, daß** der Gehäusekörper (2) stranggepreßt ist, insbesondere aus Kunststoff oder Leichtmetall.

4. Gehäusekörper nach einem der vorangehenden Ansprüche, **dadurch gekennzeichnet, daß** die Haltenuten (14) zueinander gerichtet sind.

5. Gehäusekörper nach einem der vorangehenden Ansprüche, **dadurch gekennzeichnet, daß** der erste Querschnittsbereich (10) rund ist.

6. Gehäusekörper nach einem der vorangehenden Ansprüche, **dadurch gekennzeichnet, daß** der zweite Querschnittsbereich (14) rechteckförmig ist.

7. Gehäusekörper nach einem der vorangehenden Ansprüche, **dadurch gekennzeichnet, daß** je zwei Haltenuten (14) in einer gemeinsamen Ebene angeordnet sind.

8. Gehäuse (4), insbesondere Elektronikgehäuse, mit einem Gehäusekörper (2) nach einem der vorangehenden Ansprüche und mindestens einem daran gehaltenen Deckel (30).

9. Gehäuse nach Anspruch 8, **dadurch gekennzeichnet, daß** in mindestens einem Paar von Haltenuten (14) ein Einschubteil (22, 42) aufgenommen ist, das durch mindestens einen angeschraubten Deckel gesichert ist.

10. Gehäuse nach Anspruch 9, **dadurch gekennzeichnet, daß** das Einschubteil (22) ein ebener oder profilierter Materialstreifen ist.

11. Gehäuse nach einem der Ansprüche 9 bis 10, **dadurch gekennzeichnet, daß** mindestens ein Funktionselement wie Griff, Befestigungselement, Rastelement oder Aufstellfuß an einem Einschubteil (22) oder an einem Deckel (30) gehalten oder unmittelbar in die Haltenuten (14) eingesetzt ist.

12. Gehäuse nach einem der Ansprüche 9 bis 11, **dadurch gekennzeichnet, daß** mindestens ein U-förmiger Rastbügel zur Halterung einer stirnseitig aufrastbaren Abdeckung (44) an dem Einschubteil (42) gehalten oder in die Haltenuten (14) eingesetzt ist.

13. Gehäuse nach einem der Ansprüche 8 bis 12, **dadurch gekennzeichnet, daß** der Gehäusekörper (2) im wesentlichen rechteckförmigen Querschnitt mit zwei Paaren von Befestigungskanälen (8) aufweist.

14. Gehäuse nach einem der Ansprüche 8 bis 13, **dadurch gekennzeichnet, daß** jeder Befestigungskanal (8) in einem Eckbereich (6) des Gehäusekörpers (2) angeordnet ist.

15. Gehäuse nach einem der Ansprüche 8 bis 14, **dadurch gekennzeichnet, daß** jeder Befestigungskanal (8) in einem an einem Gehäuseseite angeformten C-formigen Gehäusevorsprung (7) ausgebildet ist.

16. Gehäuse nach Anspruch 15, **dadurch gekennzeichnet, daß** die Gehäusevorsprünge (7) mit ihren offenen Bereichen die Haltenuten (14) bilden und zueinander weisend angeordnet sind.

17. Gehäuse nach einem der Ansprüche 8 bis 16, **dadurch gekennzeichnet, daß** in dem Gehäusekörper (2) in Längsrichtung verlaufende Führungen (38, 40) für Einschubelemente, insbesondere Leiterplatten, ausgebildet sind.

18. Gehäuse nach Anspruch 17, **dadurch gekennzeichnet, daß** die Führungen (38, 40) in zwei zueinander senkrechten Richtungen angeordnet sind.

19. Gehäuse nach einem der Ansprüche 16 bis 18, **dadurch gekennzeichnet, daß** auf zwei benachbarte Gehäusevorsprünge (7) ein diese formschlüssig übergreifendes Fußteil (62) aufgerastet ist.

20. Gehäuseanordnung (60) mit mindestens zwei Gehäusen (4) nach einem der Ansprüche 15 bis 19, **dadurch gekennzeichnet, daß** die Gehäuse (4) an Außenflächen aneinanderliegen, wobei je zwei Gehäuse (4) mit mindestens einem die C-förmigen Gehäusevorsprünge (7) formschlüssig übergreifenden Halteteil (62) aneinander gehalten sind, das im Querschnitt doppel-T-förmig mit einem Mittelsteg (64) und je zwei Haltestegen (66) ausgebildet ist, wobei die Haltstege (66) jeweils einen Gehäusevorsprung (7) übergreifen und der Mittelsteg (64) zwischen zwei Gehäusen (4) angeordnet ist.

21. Gehäuseanordnung nach Anspruch 20 **dadurch gekennzeichnet, daß** je zwei Gehäuse (4) mit je zwei Halteteilen (62) aneinander gehalten sind.

22. Gehäuseanordnung nach Anspruch 20 oder 21, **dadurch gekennzeichnet, daß** die Halteteile (62) elastisch und auf die Gehäuse (4) ein- und von diesen entrastbar sind.

## Claims

1. Housing body (2), in particular for an electronic housing, with a hollow profile cross-section and at least two securing channels (8) arranged in pairs formed on the outside, which are open in an outward direction and extend in the longitudinal direction of the housing body (2), to receive securing elements (32) for a cover, **characterised in that** each securing channel (8) has a first cross-section area (10) to receive a securing screw (32) and an adjoining cross-section area forming a holding groove (14) which is open in an outward direction, into which a plug-in part (22) can be inserted.

2. Housing body according to claim 1, **characterised in that** the securing elements are screws (32), in particular self-tapping screws, which are screwed into the securing channels (8).

3. Housing body according to claim 1 or 2, **characterised in that** the housing body (2) is extruded, in particular from plastic or light metal.

4. Housing body according to one of the preceding claims, **characterised in that** the holding grooves (14) are oriented towards each other.

5. Housing body according to one of the preceding claims, **characterised in that** the first cross-section area (10) is round.

6. Housing body according to one of the preceding claims, **characterised in that** the second cross-section area (14) is rectangular.

7. Housing body according to one of the preceding claims, **characterised in that** the holding grooves (14) are arranged in pairs in a common plane.

8. Housing (4), in particular an electronic housing, with a housing body (2) according to one of the preceding claims and at least one cover (30) secured thereon.

9. Housing according to claim 8, **characterised in that** a plug-in part (22, 42) which is secured by at least one screwed-on cover is received in at least one pair of holding grooves (14).

10. Housing according to claim 9, **characterised in that** the plug-in part (22) is a planar or profiled strip of material.

11. Housing according to one of claims 9 to 10, **characterised in that** at least one functional element such as handle, securing element, catch element or mounting foot is secured on a plug-in part (22) or on a cover (30) or is inserted directly into the holding grooves (14).

12. Housing according to one of claims 9 to 11, **characterised in that** at least one U-shaped latch clip for holding a covering (44) which can be latched on the front side is secured on the plug-in part (42) or inserted into the holding grooves (14).

13. Housing according to one of claims 8 to 12, **characterised in that** the housing body (2) has an essentially rectangular cross-section with two pairs of securing channels (8).

14. Housing according to one of claims 8 to 13, **characterised in that** each securing channel (8) is arranged in a corner area (6) of the housing body (2).

15. Housing according to one of claims 8 to 14, **characterised in that** each securing channel (8) is formed in a C-shaped housing projection (7) formed on one housing side.

16. Housing according to claim 15, **characterised in that** the housing projections (7) form the holding grooves (14) with their open areas, and are arranged pointing towards each other.

17. Housing according to one of claim 8 to 16, **characterised in that** longitudinally-running guides (38, 40) for plug-in parts, in particular printed circuit boards, are formed in the housing body (2).

18. Housing according to claim 17, **characterised in that** the guides (38, 40) are arranged in two directions perpendicular to each other.

19. Housing according to one of claims 16 to 18, **characterised in that** a foot part (62) is latched onto two adjacent housing projections (7), and overlaps these in a positive fit.

20. Housing arrangement (60) with at least two housings (4) according to one of claims 15 to 19, **characterised in that** the housings (4) abut each other on outer areas, each pair of housings (4) being held together by at least one holding part (62) overlapping the C-shaped housing projections (7) in a positive fit, said holding part being double-T-shaped in cross-section with a central web (64) and each having two retaining webs (66), wherein each of the retaining webs (66) overlaps a housing projection (7) and the central web (64) is arranged between two housings (4).

21. Housing arrangement according to claim 20, **characterised in that** each pair of housings (4) is held together by two holding parts (62).

22. Housing arrangement according to claim 20 or 21, **characterised in that** the holding parts (62) are flexible and can be snapped on and off the housing (4).

## Revendications

1. Corps de boîtier (2), en particulier pour boîtier électronique, ayant une section transversale en forme de profilé creux, et au moins deux canaux de fixation (8), disposés par paires, formés d'un seul tenant du côté extérieur, ouverts vers l'extérieur et s'étendant dans la direction longitudinale du corps de boîtier (2), pour recevoir des éléments de fixation (32) pour un couvercle, **caractérisé en ce que** chaque canal de fixation (8) présente une première zone de section transversale (10) pour recevoir une vis de fixation (32), et une zone de section transversale s'y raccordant, formant une rainure de maintien (14) ouverte vers l'extérieur, dans laquelle peut être insérée une partie d'insertion (22).

2. Corps de boîtier selon la revendication 1, **caractérisé en ce que** les éléments de fixation sont des vis (32), en particulier des vis auto-taraudeuses, vissées dans les canaux de fixation (8).

3. Corps de boîtier selon la revendication 1 ou 2, **caractérisé en ce que** le corps de boîtier (2) est obtenu par extrusion, en particulier en matière synthétique ou en métal léger.

4. Corps de boîtier selon l'une des revendications précédentes, **caractérisé en ce que** les rainures de maintien (14) sont tournées les unes vers les autres.

5. Corps de boîtier selon l'une des revendications précédentes, **caractérisé en ce que** la première zone de section transversale (10) est ronde.

6. Corps de boîtier selon l'une des revendications précédentes, **caractérisé en ce que** la deuxième zone de section transversale (14) est de forme rectangulaire.

7. Corps de boîtier selon l'une des revendications précédentes, **caractérisé en ce que** chaque paire de rainures de maintien (14) sont disposées dans un plan commun.

8. Boîtier (4), en particulier boîtier électronique, avec un corps de boîtier (2) selon l'une des revendications précédentes, et au moins un couvercle (30) maintenu dessus.

9. Boîtier selon la revendication 8, **caractérisé en ce que**, en au moins une paire de rainures de maintien (14) est logée une pièce d'insertion (22, 42), assurée à l'aide d'au moins un couvercle monté par vissage.

10. Boîtier selon la revendication 9, **caractérisé en ce que** la pièce d'insertion (22) est une bande de matériau plane ou profilée.

11. Boîtier selon l'une des revendications 9 à 10, **caractérisé en ce qu'**au moins un élément fonctionnel, tel que poignée, élément de fixation, élément d'encliquetage ou pied d'installation, est maintenu sur une partie d'insertion (22) ou sur un couvercle (30), ou inséré directement dans les rainures de maintien (14).

12. Boîtier selon l'une des revendications 9 à 11, **caractérisé en ce qu'**au mois un étrier à encliquetage en forme de U est maintenu sur la pièce d'insertion (42), pour maintenir un recouvrement (44), encliquetable frontalement, sur la partie d'insertion (42), ou inséré dans les rainures de maintien (14).

13. Boîtier selon l'une des revendications 8 à 12, **caractérisé en ce que** le corps de boîtier (2) présente une section transversale à forme sensiblement rectangulaire, avec deux paires de canaux de fixation (8).

14. Boîtier selon l'une des revendications 8 à 13, **caractérisé en ce que** chaque canal de fixation (8) est disposé dans une zone d'angle (6) du corps de boîtier (2).

15. Boîtier selon l'une des revendications 8 à 14, **caractérisé en ce que** chaque canal de fixation (8) est réalisé dans une saillie de boîtier (7) en forme de C, formée d'un seul tenant sur une face de boîtier.

16. Boîtier selon la revendication 15, **caractérisé en ce que** les saillies de boîtier (7) forment, par leurs zones ouvertes, les rainures de maintien (14) et sont disposées en étant tournées les unes vers les autres.

17. Boîtier selon l'une des revendications 8 à 16, **caractérisé en ce que** des guidages (38, 40), s'étendant en direction longitudinale dans le corps de boîtier (2), sont réalisés pour des éléments d'insertion, en particulier des plaquettes à circuit imprimé.

18. Boîtier selon la revendication 17, **caractérisé en ce que** les guidages (38, 40) sont disposés dans deux directions mutuellement perpendiculaires.

19. Boîtier selon l'une des revendications 16 à 18, **caractérisé en ce que**, sur deux saillies de boîtier (7) voisines, est encliquetée une partie pied (62) entourant celles-ci avec une liaison à ajustement de forme.

20. Dispositif de boîtier, avec au moins deux boîtiers (4) selon l'une des revendications 15 à 19, **caractérisé en ce que** les boîtiers (4) sont en appui les unes sur les autres, sur des faces extérieures, chaque paire de boîtiers (4) étant maintenus l'un à l'autre à l'aide d'au moins une partie de maintien (62), entourant, avec une liaison à ajustement de forme, les saillies de boîtier (7) en forme de C, la partie de maintien étant réalisée avec une section transversale en forme de double T avec une âme centrale (64) et chaque fois deux nervures de maintien (66), les nervures de maintien (66) entourant chacune une saillie de boîtier (7) et l'âme centrale (64) étant disposée entre deux boîtiers (4).

21. Dispositif de boîtier selon la revendication 20, **caractérisé en ce que** deux boîtiers (4) sont maintenus l'un contre l'autre à l'aide chaque fois de deux parties de maintien (62).

22. Dispositif de boîtier selon la revendication 20 ou 21, **caractérisé en ce que** les parties de maintien (62) sont élastiques et susceptibles d'être encliquetées sur les boîtiers (4) par insertion et d'en être désencliquetées.
